# EUROPEAN PATENT APPLICATION

(11) **EP 2 884 510 A2**
(43) Date of publication of application: **17.06.2015**
(21) Application number: 13275339.3
(22) Date of filing: 27.12.2013
(51) Int. Cl.: H01G 4/012, H01G 4/30, H01G 4/38

(54) **Array-type multilayer ceramic electronic component and mounting board therefor**

(30) Priority: 15.07.2013 KR 20130082820; 02.09.2013 KR 20130104964
(71) Applicant: Samsung Electro-Mechanics Co., Ltd, Suwon, Gyunggi-Do (KR)
(72) Inventor: Lee, Chang Ho, Gyunggi-do (KR)
(74) Representative: Powell, Timothy John

(57) **Abstract**

An array-type multilayer ceramic electronic component includes a ceramic body in which a plurality of dielectric layers are stacked in a length direction; a plurality of capacitor parts having different capacitances and including a plurality of first and second internal electrodes disposed with predetermined intervals therebetween in the length direction to be alternately exposed to both side surfaces of the ceramic body, having dielectric layers therebetween; and a plurality of first and second external electrodes disposed with predetermined intervals therebetween in the length direction and disposed on both side surfaces of the ceramic body. The plurality of respective capacitor parts include different amounts of internal electrodes stacked therein.

## Description

### CROSS-REFERENCE TO RELATED APPLICATIONS

This application claims the benefit of Korean Patent Application Nos. 10-2013-0082820 filed on July 15, 2013 and 10-2013-0104964 filed on September 2, 2013, with the Korean Intellectual Property Office, the disclosures of which are incorporated herein by reference.

### BACKGROUND

The present disclosure relates to an array-type multilayer ceramic electronic component and a mounting board therefor.

Electronic components containing a ceramic material include capacitors, inductors, piezoelectric elements, varistors, thermistors, and the like.

Among these ceramic electronic components, a multilayer ceramic capacitor (MLCC) has advantages such as a small size, high capacitance, high mountability, and the like.

MLCCs are chip-shaped condensers mounted on the circuit boards of various electronic products such as display devices, for example, liquid crystal displays (LCD), plasma display panels (PDP), or the like, computers, personal digital assistants (PDA), mobile phones, and the like, to be charged with electricity and discharge electricity.

Such an MLCC is manufactured by alternately stacking a plurality of dielectric layers and internal electrodes to form a multilayer body, firing the multilayer body, and installing external electrodes on external surfaces thereof. In general, capacitance of the MLCC is determined by the amount of stacked internal electrodes included therein.

A predetermined area needs to mount the multilayer ceramic capacitor on a printed circuit board.

In the case of mounting a plurality of MLCCs having various electric properties on a single printed circuit board, in order to properly operate each of the multilayer ceramic capacitors, a predetermined amount of space should be secured.

Recently, as electronic products have become gradually miniaturized, microminiaturization and super high capacitance have been required in the multilayer ceramic capacitors used in electronic products. However, in cases in which electronic products are slimmed and miniaturized, a space for mounting a multilayer ceramic capacitor therein is limited, so that the design of products becomes difficult.

Therefore, in order to simultaneously mount a plurality of MLCCs having various electrical properties on a single printed circuit board, there are limitations to miniaturization of electronic products.

A need exists for providing a plurality of MLCCs mounted on a printed circuit board, meeting demands for miniaturization and still having various electrical properties thereof.

### SUMMARY

An aspect of the present disclosure provides an array-type multilayer ceramic electronic component allowing an area for mounting a plurality of multilayer ceramic electronic components having various electric properties on a single board to be significantly decreased, thereby allowing a size of a mounting board to be decreased.

According to an aspect of the present disclosure, an array-type multilayer ceramic electronic component includes: a ceramic body in which a plurality of dielectric layers are stacked in a length direction; a plurality of capacitor parts having different capacitances and including a plurality of first and second internal electrodes disposed with predetermined intervals therebetween in the length direction of the ceramic body to be alternately exposed to both side surfaces of the ceramic body, having dielectric layers interposed therebetween; and a plurality of first and second external electrodes disposed with predetermined intervals therebetween in the length direction of the ceramic body and disposed on both side surfaces of the ceramic body to thereby be connected to the first and second internal electrodes of the plurality of capacitor parts. The plurality of respective capacitor parts include different amounts of internal electrodes stacked therein.

The respective capacitor parts may include dielectric layers formed of different materials.

The respective capacitor parts may include a dielectric layer formed of a BT (BaTiO₃) based material having high permittivity.

The respective capacitor parts may include a dielectric layer formed of a CT (CaTiO₃) based material having low permittivity.

Each of the capacitor parts may include a high capacitance capacitor part including a dielectric layer formed of a BT based material having a high permittivity and a low capacitance capacitor part including a dielectric layer formed of a CT based material having a low permittivity.

The first and second external electrodes may extend from both side surfaces of the ceramic body to at least one main surface of the ceramic body.

The first and second external electrodes may extend from both side surfaces of the ceramic body to both main surfaces of the ceramic body, respectively.

A buffer layer interposed between adjacent two ones of the capacitor parts in the ceramic body may be formed of a dielectric layer having a permittivity lower than that of the dielectric layer of each of the capacitor parts.

The respective capacitor parts may include different frequency bands.

According to another aspect of the present disclosure, an array-type multilayer ceramic electronic component includes a ceramic body. The ceramic body includes a first capacitor part removing noise at a low frequency band; and a second capacitor part removing noise at a high frequency band. The first and second capacitor parts are included in a single chip, and the first capacitor part has a capacitance higher than that of the second capacitor part.

The first and second capacitor parts may operate independently of each other.

The first capacitor part may compensate for instantaneous drops in voltage.

The first capacitor part may smooth direct current voltage.

The first capacitor part has a different amount of internal electrodes from that of the second capacitor part.

According to another aspect of the present disclosure, a mounting board of an array-type multilayer ceramic electronic component includes: a printed circuit board having a plurality of first and second electrode pads disposed thereon with predetermined intervals therebetween in a length direction while opposing each other in a width direction; and an array-type multilayer ceramic electronic component mounted on the plurality of first and second electrode pads.

According to another aspect of the present disclosure, an array-type multilayer ceramic electronic component includes: a first power stabilizer supplied with first power from a battery and stabilizing the first power using a first electrical storage device to supply the stabilized power to a power management IC; and a second power stabilizer supplied with second power converted in the power management IC and stabilizing the second power using a second electrical storage device to supply a driving power. The first and second electrical storage devices are configured in a single chip and have different capacitances.

The first power stabilizer may include a first terminal supplied with the first power from the battery and supplying the first power to the power management IC.

The second power stabilizer may include: a second terminal supplied with the second power converted in the power management IC and a third terminal supplying the driving power.

The first power stabilizer may decrease noise in the first power.

The second power stabilizer may decrease noise in the second power.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a perspective view of an array-type multilayer ceramic capacitor according to an embodiment of the present disclosure;
FIG. 2 is a perspective view of a structure in which a ceramic body and internal electrodes of the array-type multilayer ceramic capacitor according to an embodiment of the present disclosure are exposed;
FIG. 3 is a graph illustrating impedances versus frequencies of first and second capacitor parts of the array-type multilayer ceramic capacitor according to an embodiment of the present disclosure;
FIG. 4 is an exploded perspective view of a structure in which a plurality of capacitor parts and buffer layers of the array-type multilayer ceramic capacitor according to an embodiment of the present disclosure are stacked;
FIG. 5 is a perspective view of a structure in which an array-type multilayer ceramic capacitor according to an embodiment of the present disclosure is mounted on a printed circuit board;
FIG. 6 is a plan view of the structure of FIG. 5;
FIG. 7 illustrates a driving power supply system supplying a driving power to a predetermined terminal requiring driving power via a battery and a power management unit;
FIG. 8 illustrates an arrangement pattern of the driving power supply system;
FIG. 9 is a circuit diagram of an array-type multilayer ceramic electronic component according to an embodiment of the present disclosure; and
FIG. 10 illustrates an arrangement pattern of a driving power supply system using a composite electronic component according to an embodiment of the present disclosure.

### DETAILED DESCRIPTION

Exemplary embodiments of the present disclosure will now be described in detail with reference to the accompanying drawings.

The disclosure may, however, be exemplified in many different forms and should not be construed as being limited to the specific embodiments set forth herein. Rather, these embodiments are provided so that this disclosure will be thorough and complete, and will fully convey the scope of the disclosure to those skilled in the art.

In the drawings, the shapes and dimensions of elements may be exaggerated for clarity, and the same reference numerals will be used throughout to designate the same or like elements.

Hereinafter, an array-type multilayer ceramic electronic component, particularly, an array-type multilayer ceramic capacitor (MLCC) will be described, but the present disclosure is not limited thereto.

### Array-Type Multilayer Ceramic Capacitor

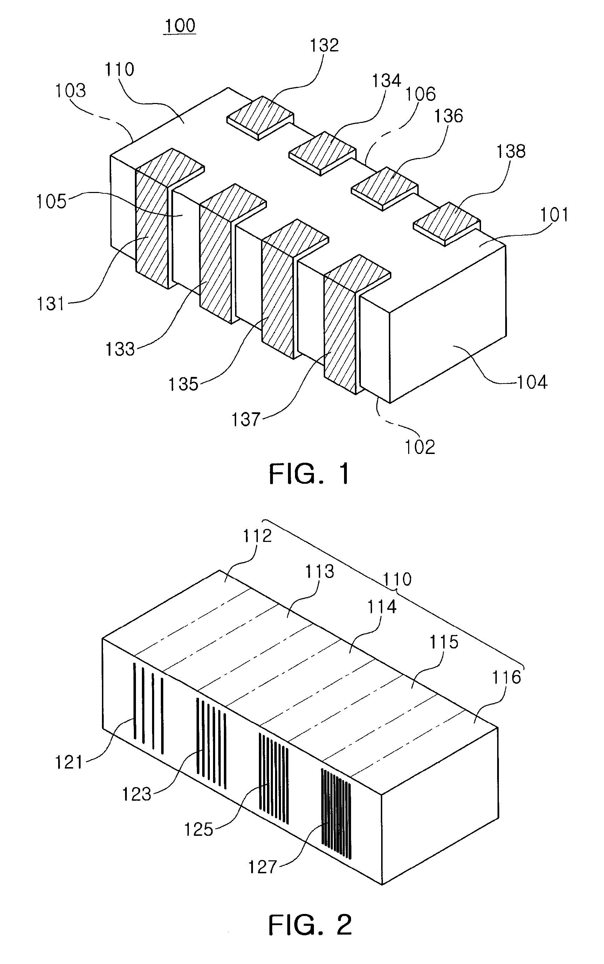

FIG. 1 is a perspective view of an array-type multilayer ceramic capacitor (MLCC) according to an embodiment of the present disclosure, and FIG. 2 is a perspective view of a structure in which a ceramic body and internal electrodes of the array-type MLCC according to an embodiment of the present disclosure are exposed.

Referring to FIGS. 1 and 2, the array-type MLCC 100 includes a ceramic body 110, a plurality of capacitor parts having different capacitances and including a plurality of first internal electrodes 121, 123, 125, and 127 and a plurality of second internal electrodes 122, 124, 126, and 128, respectively, and a plurality of first external electrodes 131, 133, 135, and 137 and a plurality of second external electrodes 132, 134, 136, and 138.

The plurality of capacitor parts according to the present embodiment of the present disclosure may include different amounts of internal electrodes stacked therein. For example, in the present embodiment, the amounts of first internal electrodes 121, 123, 125, and 127 and second internal electrodes 122, 124, 126, and 128 stacked in the respective capacitor parts may be different from each other, such that capacitances of the respective internal electrodes differ from each other.

Therefore, a plurality of capacitor parts having high or low capacitance may be implemented in a single chip by controlling the amount of internal electrodes stacked in the respective capacitor parts.

In this case, in the plurality of capacitor parts, a frequency region may be different according to the capacitance, and hereinafter, a capacitor part having a high capacitance may be defined as a first capacitor part, and a capacitor part having a relatively low capacitance as compared to the first capacitor part may be defined as a second capacitor part.

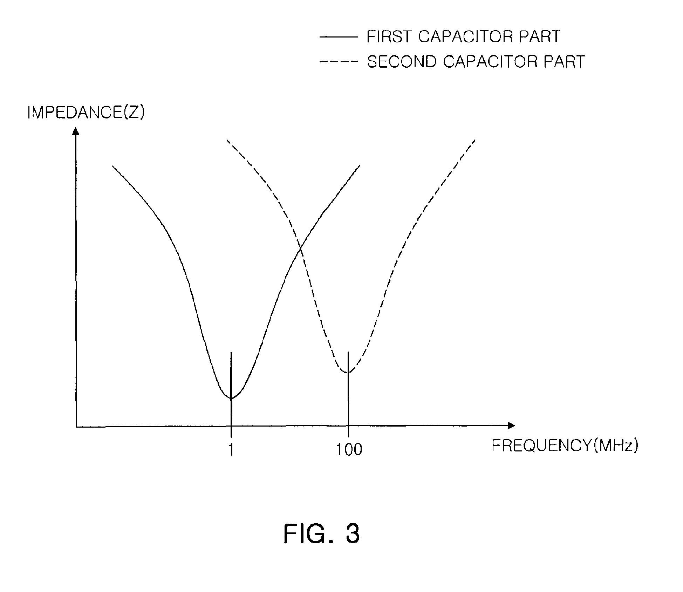

FIG. 3 is a graph illustrating impedances versus frequencies of first and second capacitor parts of the array-type MLCC according to an embodiment of the present disclosure.

Here, the capacitance of the first capacitor part may be about 22µF and the capacitance of the second capacitor part may be about 1nF, but the present disclosure is not limited thereto.

Further, in the present embodiment, although low and high frequency bands are distinguished from each other based on a frequency of 100MHz, this is only an example, and the present disclosure is not limited thereto.

Referring to FIG. 3, the first capacitor part may serve as a filter in the low frequency band to attenuate noise at the low frequency band, and the second capacitor part may attenuate noise at the high frequency band.

In this case, the first and second capacitor parts may operate independently.

In addition, the first capacitor part may play a backup role in compensating for instantaneous drops in voltage and a role of smoothing direct current voltage, when needed. Here, smoothing refers to an operation of weakening or removing a change or discontinuity when a fine change, discontinuity, or the like, having a negative influence on data is generated due to coarse sampling or noise.

In addition, the second capacitor part may be used as a matching device for an LC circuit matching according to the change in temperature, when needed.

Meanwhile, buffer layers 113, 114, and 115, on which the internal electrode is not formed, may be interposed between the plurality of capacitor parts, respectively, and cover layers 112 and 116 may be formed on both end portions of the ceramic body 110 in a length direction.

The ceramic body 110 is formed by stacking a plurality of dielectric layers 111 in the length direction and then firing them, wherein adjacent dielectric layers 111 may be integrated, such that boundaries therebetween may be difficult to discern without the use of a scanning electron microscope (SEM).

A shape of the ceramic body 110 is not particularly limited, but may be, for example, hexahedral.

In the present embodiment, for convenience of explanation, surfaces of the ceramic body 110 opposing each other in a thickness direction may be defined as first and second main surfaces 101, 102, surfaces connecting the first and second main surfaces to each other and opposing each other in the length direction may be defined as first and second end surfaces 103, 104, and surfaces opposing each other in a width direction may be defined as first and second side surfaces 105, 106.

The dielectric layer 111 may contain a ceramic material having high permittivity, for example, a barium titanate (BaTiO₃)-based ceramic powder, or the like, but the present disclosure is not limited thereto as long as sufficient capacitance may be obtained.

In addition, the dielectric layer 111 may further contain various ceramic additives such as transition metal oxides or carbides, a rare earth element, magnesium (Mg), aluminum (Al), or the like, an organic solvent, a plasticizer, a binder, a dispersant, or the like, in addition to the ceramic powder, when needed.

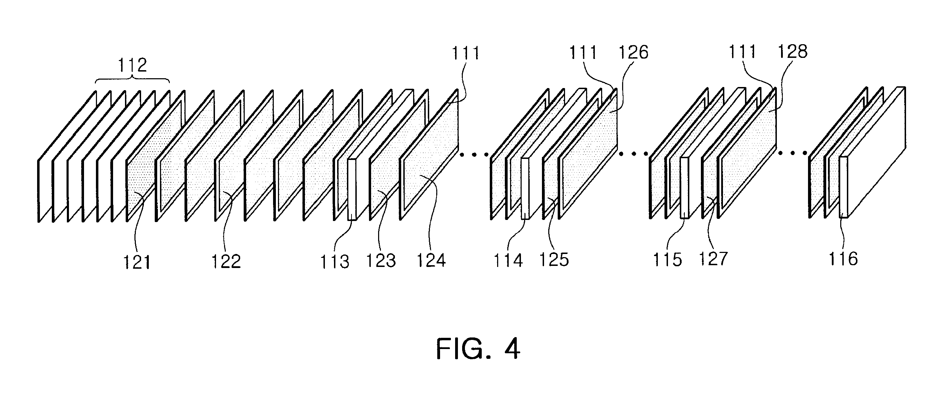

FIG. 4 is an exploded perspective view of a structure in which capacitor parts and buffer layers of the array-type MLCC according to the embodiment of the present disclosure are stacked.

Referring to FIG. 4, the capacitor part according to the embodiment of the present disclosure may have a structure in which the dielectric layers 111, the first internal electrodes 121, 123, 125, and 127, and the second internal electrodes 122, 124, 126, and 128 are stacked in the length direction of the ceramic body 110.

Unlike the present disclosure, in the case in which the first and second internal electrodes are multilayered in the thickness direction, the same capacitance may be implemented in each of the capacitor parts, but in the case of allowing the capacitance of each of the capacitor parts to be different, an area of the internal electrode in each of the capacitor parts needs to be changed.

However, in the present embodiment, the first internal electrodes 121, 123, 125, and 127 and the second internal electrodes 122, 124, 126, and 128 are stacked in the length direction and vertically configured, such that the amounts of multi-layered first internal electrodes 121, 123, 125, and 127 and second internal electrodes 122, 124, 126, and 128 may be different, thereby allowing the plurality of capacitors to easily have different capacitances from each other.

For example, in an array-type MLCC in which the internal electrodes are horizontally stacked, in the case of manufacturing an array having various capacitance combinations, since patterns of the internal electrodes need to be differently designed and formed in each of the capacitor parts, a problem in a process may be generated. However, in the present embodiment, since only the amount of stacked internal electrodes in each of the capacitor parts is changed, an array-type multilayer ceramic capacitor having various capacitance combinations may be easily manufactured without an additional process or additional equipment.

In addition, in the array-type multilayer ceramic capacitor in which the internal electrodes are horizontally configured, a portion connected to an external electrode is narrowly formed, such that connectivity with the external electrode may be deteriorated, and a relatively high equivalent series resistance (ESR) may be provided, but in the present embodiment, lengths of portions of the first internal electrodes 121, 123, 125, and 127 and the second internal electrodes 122, 124, 126, and 128 exposed to the first and second side surfaces 105, 106 of the ceramic body 110 are relatively long, such that connectivity with the first external electrodes 131, 133, 135, and 137 and the second external electrodes 132, 134, 136, and 138 may be improved, a relatively low ESR may be implemented, and adhesion strengths may also be improved.

Further, in the array-type MLCC in which the internal electrodes are horizontally configured, a pass of current penetrates through a central portion of the ceramic body, but in the present embodiment, since a pass of the current flows along lower portions of the first internal electrodes 121, 123, 125, and 127 and the second internal electrodes 122, 124, 126, and 128, the current path may be short as compared to the array-type multilayer ceramic capacitor in which the internal electrodes are horizontally configured, thereby implementing lower ESR.

In this case, each of the capacitor parts may include a dielectric layer formed of a barium titanate (BT) based material having a high permittivity, when needed. On the contrary, each of the capacitor parts may include a dielectric layer containing a CT (Calcium titanate) based material having a low permittivity as a main raw material.

In addition, the plurality of capacitor parts may be configured with dielectric layers all of which are formed of the same material and have the same permittivity or be configured with dielectric layers some or all of which are formed of different materials and have different degrees of permittivity.

As another example, each of the capacitor parts may be configured in consideration of capacitance, so that a high capacitance capacitor part includes the dielectric layer formed of the BT based material having high permittivity, and a low capacitance capacitor part includes the dielectric layer formed of the CT based material having low permittivity.

However, even in the case in which the capacitor part according to the embodiment of the present disclosure is the high capacitance capacitor part, the capacitor part may be changed in various shapes and structures, for example, by increasing the amount of stacked dielectric layers while using a dielectric layer having low permittivity in order to increase an ESR value.

The buffer layers 113 to 115 configured with a plurality of ceramic sheets may be interposed between the capacitor parts, the capacitor parts may be disposed with predetermined intervals therebetween in the length direction of the ceramic body 110, and the cover layers 112 and 116 composed of a plurality of ceramic sheets may be disposed on both end portions of the ceramic body 110 in the length direction.

The buffer layers 113 to 115 and the cover layers 112 and 116 may have the same structure as those of the dielectric layer 111 of the capacitor part except that the internal electrode is not formed therein.

However, the present disclosure is not limited thereto, but the dielectric layer configured with the buffer layers 113 to 115 may be formed using a material having a permittivity relatively lower than that of the dielectric layer 111 of the capacitor part, when needed.

In this case, parasitic capacitances generated between the capacitor parts may be more effectively removed.

The first internal electrodes 121, 123, 125, or 127 and the second internal electrodes 122, 124, 126, or 128 of each of the capacitor parts, which are electrodes having different polarities from each other, may be alternately disposed so as to face each other, having a ceramic sheet forming the dielectric layer 111 therebetween, to thereby be alternately exposed through the first and second side surfaces.

Here, the first internal electrodes 121, 123, 125, and 127 and the second internal electrodes 122, 124, 126, and 128 may be electrically insulated from each other by the dielectric layer 111 disposed therebetween.

In addition, the first internal electrodes 121, 123, 125, and 127 and the second internal electrodes 122, 124, 126, and 128 may be formed of a conductive metal, for example, one of silver (Ag), palladium (Pd), platinum (Pt), nickel (Ni), and copper (Cu), an alloy thereof, or the like, but the present disclosure is not limited thereto.

In this case, when the first and second internal electrodes are stacked in the thickness direction unlike the present disclosure, the materials of the dielectric layers applied to each of the capacitor parts need to be the same as each other. However, since the capacitor parts of the present disclosure are distinguished from each other by the buffer layers 113 to 115 in the length direction of the ceramic body 110, a material of a dielectric layer 111 may be different from that of a dielectric layer 111 of another capacitor part.

Therefore, the respective capacitor parts may have various combinations of capacitance in a single array-type multilayer ceramic electronic component at the time of implementing different capacitances, due to differences in properties of materials forming the dielectric layers 111 as described above.

The first external electrodes 131, 133, 135, and 137 and the second external electrodes 132, 134, 136, and 138 may be disposed with predetermined intervals therebetween in the length direction of the ceramic body 110 on the first and second side surfaces 105, 106 of the ceramic body 110, in further detail, in positions corresponding to those of the capacitor parts, respectively.

Therefore, the first external electrodes 131, 133, 135, and 137 and the second external electrodes 132, 134, 136, and 138 may contact end portions of the first internal electrodes 121, 123, 125, and 127 and the second internal electrodes 122, 124, 126, and 128 of the plurality of ceramic capacitor parts alternately exposed through the first and second side surfaces 105, 106 of the ceramic body 110, respectively, to thereby be electrically connected to each other.

In this case, the first external electrodes 131, 133, 135, and 137 and the second external electrodes 132, 134, 136, and 138 may extend from the first and second side surfaces 105, 106 of the ceramic body 110 to at least portions of the second main surface, a mounting surface, in order to provide a lower mounting surface.

Further, the first external electrodes 131, 133, 135, and 137 and the second external electrodes 132, 134, 136, and 138 may be extended from the first and second side surfaces of the ceramic body 110 to portions of the first main surface 101.

In the case in which internal and external structures of the array-type multilayer ceramic capacitor 100 are formed so as to be vertically symmetrical with respect to each other by extending the first external electrodes 131, 133, 135, and 137 and the second external electrodes 132, 134, 136, and 138 from the first and second side surfaces 105, 106 of the ceramic body 110 to the portions of the first main surface 101, an opposite surface facing the mounting surface of the ceramic body 110, since directionality of the capacitor may be removed, at the time of surface-mounting of the capacitor, any one of the first and second main surfaces 101, 102 of the ceramic body 110 may become the mounting surface.

Therefore, at the time of mounting the array-type multilayer ceramic capacitor 100 on a printed circuit board, a direction of the mounting surface should not be considered.

In addition, the first external electrodes 131, 133, 135, and 137 and the second external electrodes 132, 134, 136, and 138 may be formed of a conductive metal, for example, silver (Ag), nickel (Ni), Copper (Cu), or the like.

The first external electrodes 131, 133, 135, and 137 and the second external electrodes 132, 134, 136, and 138 may be formed by applying a conductive paste prepared by adding glass frit to the conductive metal powder to then be fired, but the present disclosure is not limited thereto.

Further, a plating layer (not shown) may be formed on a mounting surface of the first external electrodes 131, 133, 135, and 137 and the second external electrodes 132, 134, 136, and 138, for example, the second main surface 102 in the present embodiment, when needed. The plating layer is to increase adhesion strength between the multilayer ceramic capacitor 100 and the printed circuit board at the time of mounting the multilayer ceramic capacitor 100 on the printed circuit board by solder.

The plating layer may include, for example, a nickel (Ni) plating layer formed on the first external electrodes 131, 133, 135, and 137 and the second external electrodes 132, 134, 136, and 138 on the second main surface 102 and a tin (Sn) plating layer formed on the nickel plating layer, but the present disclosure is not limited thereto.

In addition, the plating layer may be formed on the first external electrodes 131, 133, 135, and 137 and the second external electrodes 132, 134, 136, and 138 on the first main surface 101, when needed.

Hereinafter, a manufacturing method of the array-type MLCC according to an embodiment of the present disclosure will be described.

First, a plurality of ceramic sheets may be prepared.

The ceramic sheet, provided to form the dielectric layer of the ceramic body, may be manufactured by mixing ceramic powder, a binder, and a solvent to prepare slurry and forming the prepared slurry as a sheet having a thickness of several µm by a doctor blade method, or the like.

Next, first and second internal electrodes may be formed by printing a conductive paste on one surfaces of the respective ceramic sheets to a predetermined thickness.

As a method of printing the conductive paste, a screen printing method, a gravure printing method, or the like, may be used, and the conductive paste may contain metal powder, ceramic powder, silica (SiO₂) powder, and the like.

As the metal powder, at least one of a noble metal such as silver (Ag), lead (Pb), platinum (Pt), or the like, nickel (Ni), manganese (Mn), chromium (Cr), cobalt (Co), aluminum (Al), and copper (Cu), or an alloy thereof may be used.

Next, a plurality of ceramic sheets including the first and second internal electrodes formed thereon may be stacked so that the first and second internal electrodes are disposed to face each other, having the ceramic sheet therebetween, thereby forming a plurality of capacitor parts.

In this case, the plurality of capacitor parts may be formed so as to have different capacitances.

For example, in the plurality of capacitor parts, the respective capacitor parts may have a different capacitance by controlling the amount of ceramic sheets on which the first and second internal electrodes are formed in each of the capacitor parts.

In addition, the respective capacitor parts may be formed using ceramic sheets having different levels of permittivity to each other. Therefore, at the time of implementing different capacitances in the respective capacitor parts, more various capacitance combinations may be implemented in a single array-type multilayer ceramic electronic component due to the differences in permittivity between the ceramic sheets as described above.

Thereafter, the plurality of capacitor parts may be stacked in the length direction so that buffer layers composed of a plurality of ceramic sheets are disposed between the capacitor parts, respectively, and then pressed, thereby preparing a multilayer body including the plurality of capacitor parts disposed with predetermined intervals therebetween in the length direction.

In this case, the ceramic sheet of the buffer layer may be formed of a material having a permittivity lower than that of the ceramic sheet of the capacitor part.

Next, the multilayer body may be cut into portions corresponding to single chips and be fired, thereby preparing a ceramic body having first and second main surfaces 101, 102 opposing each other in a thickness direction, first and second end surfaces 103, 104 in a length direction, and first and second side surfaces 105, 106 to which the first and second internal electrodes are alternately exposed in a width direction.

Then, a plurality of first and second external electrodes may be formed with predetermined intervals therebetween on the first and second side surfaces 105, 106 of the ceramic body in the length direction of the ceramic body so as to contact the first and second internal electrodes of the plurality of capacitor parts to thereby be electrically connected thereto, respectively.

In this case, the first and second external electrodes may extend from the first and second side surfaces 105, 106 of the ceramic body to portions of the first or second main surface 101, 102 in order to allow a lower surface to become a mounting surface.

Further, the first and second external electrodes may extend from the first and second side surfaces 105, 106 of the ceramic body to portions of the first and second main surfaces 101, 102 such that directionality of the mounting surface does not need to be considered at the time of mounting the capacitor, by removing directionality of the capacitor.

Meanwhile, a plating layer may be formed on the mounting surface of the first and second external electrodes, when needed. The plating layer is provided to increase adhesion strength between the completed array-type MLCCand the printed circuit board at the time of mounting the completed array-type MLCC on the printed circuit board by solder.

### Mounting board for array-type MLCC

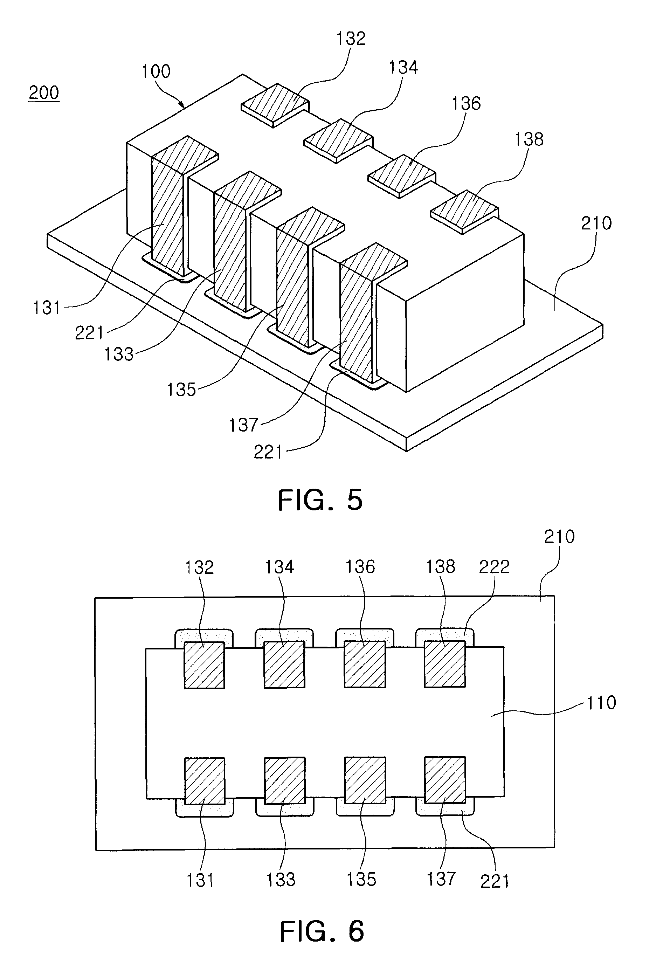

FIG. 5 is a perspective view schematically illustrating a structure in which the array-type MLCC according to the embodiment of the present disclosure is mounted on a printed circuit board, and FIG. 6 is a plan view of the structure of FIG. 5.

Referring to FIGS. 5 and 6, the mounting board 200 for the array-type MLCC according to the present embodiment includes a printed circuit board 210 and first and second electrode pads 221 and 222.

The second main surface of the ceramic body 110 of the array-type MLCC 100 may be mounted on an upper surface of the printed circuit board 210.

The first and second electrode pads 221 and 222 may be disposed with predetermined intervals therebetween on the upper surface of the printed circuit board 210 in the length direction while opposing each other in the width direction.

For example, a plurality of first and second electrode pads 221 and 222 may be formed on the upper surface of the printed circuit board 210 corresponding to the first external electrodes 131, 133, 135, or 137 and the second external electrodes 132, 134, 136, or 138 in each of the capacitor parts of the array-type MLCC 100, respectively.

Therefore, the array-type MLCC 100 may be electrically connected to the printed circuit board 210 with solder (not shown) in a state in which the first external electrodes 131, 133, 135, and 137 and the second external electrodes 132, 134, 136, and 138 on the second main surface 102 are positioned on the plurality of first and second electrode pads 221, 222 electrode pads 221 and 222 so as to contact each other, respectively.

### Further embodiment

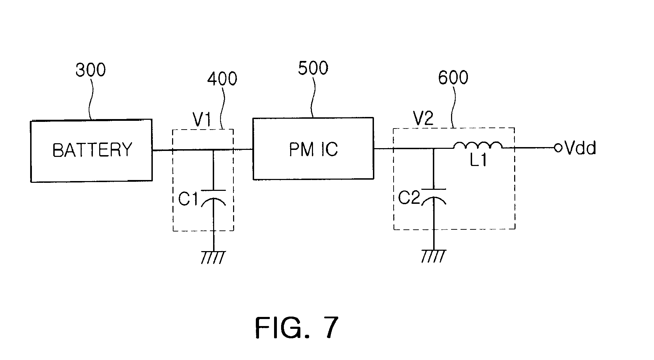

FIG. 7 is a view illustrating a driving power supply system supplying a driving power to a predetermined terminal requiring the driving power via a battery and a power management unit.

Referring to FIG. 7, the driving power supply system includes a battery 300, a first power stabilizer 400, a power management IC 500, and a second power stabilizer 600.

The battery 300 may supply power to the power management IC 500. Here, power supplied to the power management IC 500 by the battery 300 will be defined as first power.

The first power stabilizer 400 may stabilize the first power V₁ and supply the stabilized first power to the power management IC500. In detail, the first power stabilizer 400 may include a capacitor C₁ formed between a connection terminal of the battery 300 and the power management IC 500 and a ground. The capacitor C₁ may reduce noise included in the first power.

In addition, the capacitor C₁ may charge electric charges. Further, in the case in which the power management IC 500 instantaneously consumes a large amount of current, the capacitor C₁ may discharge the charged electric charges to suppress a voltage of the power management IC 500 from being changed.

The capacitor C₁ may be a high capacitance capacitor.

The power management IC 500 may serve to convert power supplied to an electronic apparatus so as to be suitable for the electronic apparatus and distribute, charge, and control the power. Therefore, the power management IC 500 may generally include a DC/DC converter.

In addition, the power management IC 500.

The power management IC 500 may convert the first power V₁ into second power V₂. The second power V₂ may be power required in a predetermined device connected to an output terminal of the power management IC 500 to thereby be supplied with the driving power.

The second power stabilizer 600 may stabilize the second power V₂ and supply the stabilized second power to an output terminal V_{dd}. A predetermined device supplied with the driving power from the power management IC 500 may be connected to the output terminal V_{dd}.

In further detail, the second power stabilizer 600 may include an inductor L₁ connected in series between the power management unit 500 and the output terminal V_{dd}. In addition, the second power stabilizer 600 may include a capacitor C₂ formed between a connection terminal of the power management IC 500 and the output terminal V_{dd} and the ground.

The second power stabilizer 600 may reduce noise included in the second power V₂.

Further, the second power stabilizer 600 may stably supply power to the output terminal V_{dd}.

The inductor L₁ may be a power inductor capable of being applied to large-capacity current.

In addition, the capacitor C₂ may be a high capacitance capacitor.

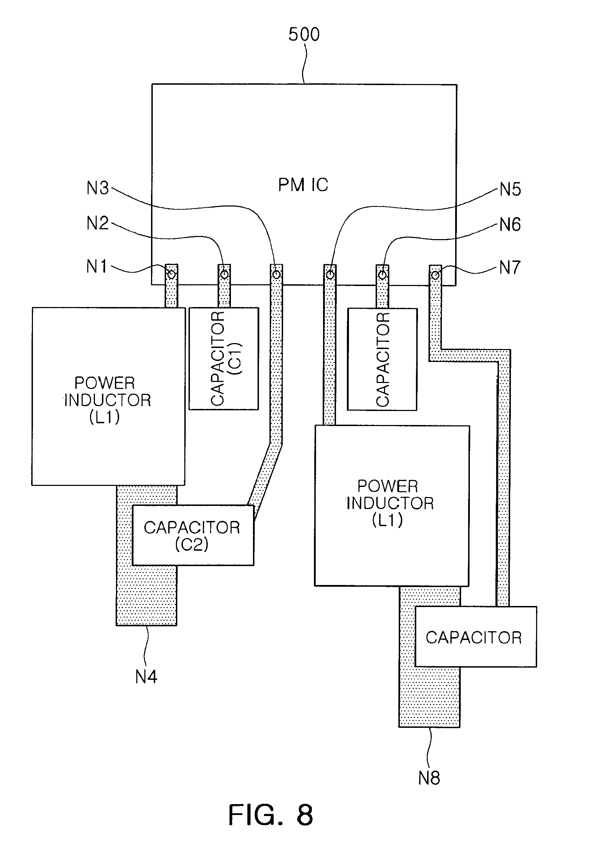

FIG. 8 is a view illustrating an arrangement pattern of the driving power supply system.

Referring to FIG. 8, an arrangement pattern of the power management IC 500, the inductor L₁, the first capacitor C₁, and the second capacitor C₂ may be confirmed.

Generally, the power management IC (PMIC) 500 may include several to several tens of DC/DC converters. Further, in order to implement a function of the DC/DC converter, a power inductor and a high capacitance capacitor may be required in each of the DC/DC converters.

Referring to FIG. 8, the power management IC 500 may include predetermined terminals N1, N2, and N3. The power management IC 500 may be supplied with the power from the battery via the second terminal N2. In addition, the power management IC 500 may convert the power supplied from the battery and supply the converted power via the first terminal N1. The third terminal N3 may be the ground terminal.

Here, the first capacitor C₁ may be formed between the connection terminal of the battery and the power management IC 500 and the ground to perform functions of the first power stabilization unit.

In addition, since the inductor L₁ and the second capacitor C₂ are supplied with the second power from the first terminal N1 and stabilize the supplied second power to supply driving power to a fourth terminal N4, the inductor L₁ and the second capacitor C₂ may perform functions of the second power stabilizer 600.

Since fifth to eighth terminals N5 to N8 shown in FIG. 8 perform the same functions as those of the first to fourth terminals N1 to N4, a detailed description thereof will be omitted.

In a pattern design of the driving power supply system, the important consideration is that the power management IC, an inductor device, and a capacitor device need to be arranged as close to each other as possible. In addition, wiring of a power line needs to be designed to be relatively thick and short.

Only in the case in which the above-mentioned conditions are satisfied, a component arrangement area may be reduced, and the generation of noise may be suppressed.

In the case in which the amount of output terminals of the power management IC 500 is relatively small, there is no problem in arranging the inductor device and the capacitor device to be closely adjacent to each other. However, in the case of using various output terminals of the power management IC 500, the inductor device and the capacitor device may not be able to be normally arranged, due to density of components. In addition, the inductor device and the capacitor device may need to be arranged in a non-optimal state according to the priority of power.

For example, since sizes of a power inductor device and a high capacitance device are relatively large, at the time of actually arranging the devices, a power line and a signal line may be unavoidably long.

In the case in which the power inductor and the high capacitance capacitor are arranged in the non-optimal state, an interval between the devices and the power lines may be elongated, thereby generating noise. The noise may have a negative influence on the power supply system.

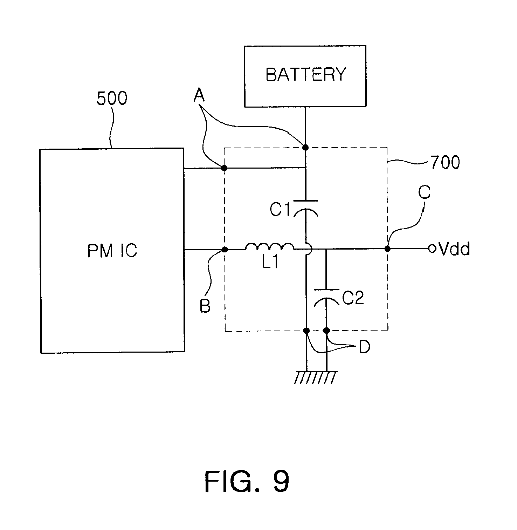

FIG. 9 is a view illustrating a circuit diagram of the array-type multilayer ceramic electronic component according to an embodiment of the present disclosure.

Referring to FIG. 9, the array-type multilayer ceramic electronic component 700 includes a first power stabilization power stabilizer and a second power stabilizer.

The first power stabilizer may include a first capacitor unit C₁, a first electrical storage device. The second power stabilizerunit may include a second capacitor unit C₂, a second electrical storage device. In this case, the first and second capacitor units may be configured as a single chip included in a single ceramic body. In addition, the second power stabilizer may include a first power inductor L₁.

Further, the array-type multilayer ceramic electronic component 700 may be a device capable of performing all functions of the first and second power stabilization units as described above.

The array-type multilayer ceramic electronic component 700 may be supplied with a first power from a battery and stabilize the supplied first power to supply the stabilized power to a power management IC. In this case, a terminal A supplied with the first power from the battery and a terminal A supplying the first power to the power management IC may be the same as each other. For example, the first terminal A (first input terminal) may be supplied with the first power from the battery and supply the first power to the power management IC.

In addition, the array-type multilayer ceramic electronic component 700 may be supplied with a second power power converted by the power management IC via a second terminal B (second input terminal).

Further, the array-type multilayer ceramic electronic component 700 may stabilize the second power to transfer driving power to a third terminal C (output terminal).

Referring to FIG. 9, the first power inductor L₁ and the second capacitor unit C₂ share the third terminal with each other, such that an interval between the first power inductor L₁ and the second capacitor unit C₂ may be reduced.

Meanwhile, the array-type multilayer ceramic electronic component 700 may include a fourth terminal D (ground terminal) capable of connecting the first and second capacitor units C₁ and C₂ to the ground. The fourth terminal D may be implemented as a single terminal.

As described above, in the array-type multilayer ceramic electronic component 700, the first capacitor unit provided with an input power terminal of the power management IC 500 and having a high capacitance, and the second capacitor unit provided with an output power terminal of the power management IC 500 and having a capacitance different from that of the first capacitor unit are implemented as the single component (chip) in the single ceramic body, and the power inductor is included therein, such that the array-type multilayer ceramic electronic component 700 according to the present embodiment may improve a degree of integration of the device.

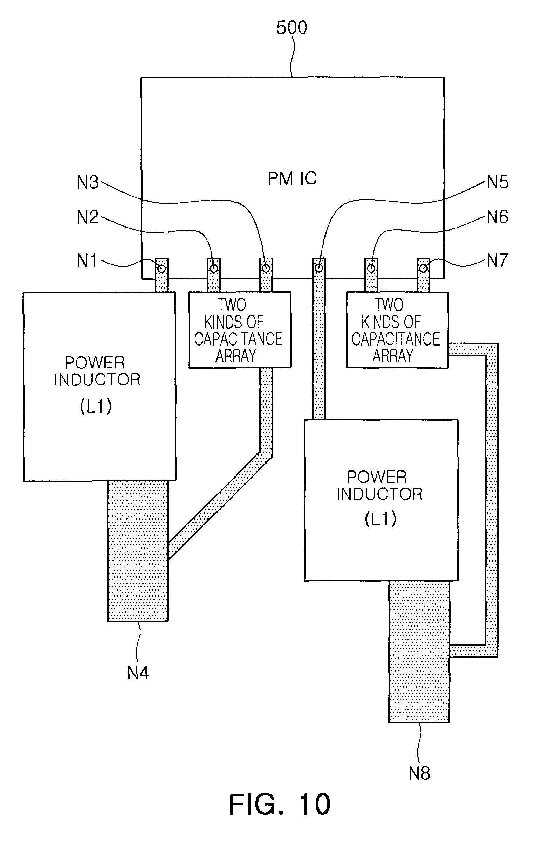

FIG. 10 is a view illustrating an arrangement pattern of a driving power supply system using a composite electronic component according to the embodiment of the present disclosure.

Referring to FIG. 10, it may be confirmed that the first and second capacitors C₁ and C₂ shown in FIG. 8 are replaced with the array-type multilayer ceramic electronic component according to the embodiment of the present disclosure.

As described above, the array-type multilayer ceramic electronic component may perform the functions of the first and second power stabilization units.

In addition, a length of wiring may be significantly reduced by replacing the individually configured first and second capacitors C₁ and C₂ with the array-type multilayer ceramic electronic component according to the embodiment of the present disclosure. In addition, the amount of arranged devices is decreased, such that the devices may be arranged to be suitable therefor.

For example, according to the embodiment of the present disclosure, the power management unit and the power inductor may be arranged as close to one another as possible, and the first and second capacitor units may be configured in the single chip, such that the wiring of the power line may be designed so as to be relatively short and thick.

Meanwhile, in order to satisfy customer needs, electronic apparatus manufacturers have been made efforts to decrease the size of printed circuit boards (PCB) included in the electronic apparatus. Therefore, there is a demand for increasing a degree of integration of an integrated circuit (IC) mounted in the PCB. This demand may be satisfied by configuring a plurality of devices in a single composite electronic component, similarly to the composite electronic component according to the embodiment of the present disclosure.

In addition, according to an embodiment of the present disclosure, a mounting area of the PCB may be decreased by configuring the first and second capacitors in the single chip and including the power inductor therein to thereby implement the single composite electronic component. According to the embodiment of the present disclosure, the mounting area may be decreased by about 30 to 50% as compared to the existing arrangement pattern.

As set forth above, according to exemplary embodiments of the present disclosure, an area for individually mounting a plurality of multilayer ceramic electronic components having various electric properties on a single board may be decreased by configuring the plurality of capacitor parts to have different capacitances from each other and to be connected in parallel with each other in the single ceramic body. As a result, the size of the mounting board may be decreased.

In addition, when the multilayer ceramic electronic components are mounted on the printed circuit board, the amount of picking-up may be decreased, whereby manufacturing productivity may be improved.

Further, the internal electrode may be formed in a direction vertical to the mounting surface, such that the exposed surface of the internal electrode contacting the external electrode may be increased, thereby increasing connectivity between the internal electrode and the external electrode to improve ESR and enhancing adhesion strength that prevents the external electrode from being delaminated from the ceramic body.

While exemplary embodiments have been shown and described above, it will be apparent to those skilled in the art that modifications and variations could be made without departing from the spirit and scope of the present disclosure as defined by the appended claims.

## Claims

1. An array-type multilayer ceramic electronic component comprising:
a ceramic body including:
a plurality of dielectric layers stacked in a length direction thereof;
a plurality of capacitor parts having different capacitances, the plurality of capacitor parts including (i) a plurality of first and second internal electrodes disposed with predetermined intervals therebetween in the length direction of the ceramic body to be alternately exposed to both side surfaces of the ceramic body, and (ii) dielectric layers interposed between the plurality of first and second internal electrodes; and
a plurality of first and second external electrodes disposed with predetermined intervals therebetween in the length direction of the ceramic body and disposed on both side surfaces of the ceramic body to thereby be connected to the first and second internal electrodes of the plurality of capacitor parts,
wherein the plurality of respective capacitor parts include different amounts of first or second internal electrodes stacked therein.

2. The array-type multilayer ceramic electronic component of claim 1, wherein the respective capacitor parts include dielectric layers formed of different materials.

3. The array-type multilayer ceramic electronic component of claim 1, wherein the respective capacitor parts include a dielectric layer formed of a BT (BaTiO₃) based material having a high permittivity.

4. The array-type multilayer ceramic electronic component of claim 1, wherein the respective capacitor parts include a dielectric layer formed of a CT based material having a low permittivity.

5. The array-type multilayer ceramic electronic component of claim 1, wherein each of the capacitor parts includes a high capacitance capacitor part including a dielectric layer formed of a BT based material having a high permittivity and a low capacitance capacitor part including a dielectric layer formed of a CT based material having a low permittivity.

6. The array-type multilayer ceramic electronic component of claim 1, wherein the first and second external electrodes extend from both side surfaces of the ceramic body to at least one main surface of the ceramic body.

7. The array-type multilayer ceramic electronic component of claim 1, wherein the first and second external electrodes extend from both side surfaces of the ceramic body to both main surfaces of the ceramic body, respectively.

8. The array-type multilayer ceramic electronic component of claim 1, wherein a buffer layer interposed between two adjacent ones of the capacitor parts in the ceramic body is formed of a dielectric layer having a permittivity lower than that of the dielectric layer of each of the capacitor parts.

9. An array-type multilayer ceramic electronic component comprising:
a ceramic body including:
a first capacitor part removing noise at a low frequency band; and
a second capacitor part removing noise at a high frequency band;
wherein the first capacitor part has a capacitance higher than that of the second capacitor part.

10. The array-type multilayer ceramic electronic component of claim 9, wherein the first and second capacitor parts operate independently of each other.

11. The array-type multilayer ceramic electronic component of claim 9, wherein the first capacitor part compensates for instantaneous drops in voltage.

12. The array-type multilayer ceramic electronic component of claim 9, wherein the first capacitor part smoothes direct current voltage.

13. The array-type multilayer ceramic electronic component of claim 9, wherein the first capacitor part has a different amount of internal electrodes from that of the second capacitor part.

14. An array-type multilayer ceramic electronic component comprising:
a first power stabilizer supplied with a first power from a battery and stabilizing the first power using a first electrical storage device to supply the stabilized power to a power management IC; and
a second power stabilizer supplied with a second power converted in the power management IC and stabilizing the second power using a second electrical storage device to supply a driving power,
wherein the first and second electrical storage devices are configured in a single chip and have different capacitances.

15. The array-type multilayer ceramic electronic component of claim 14, wherein the first power stabilizer includes a first terminal supplied with the first power from the battery and supplying the first power to the power management IC.

16. The array-type multilayer ceramic electronic component of claim 14, wherein the second power stabilizer includes:
a second terminal supplied with the second power converted by the power management IC; and
a third terminal supplying the driving power.

17. The array-type multilayer ceramic electronic component of claim 14, wherein the first power stabilizer decreases noise in the first power.

18. The array-type multilayer ceramic electronic component of claim 14, wherein the second power stabilizer decreases noise in the second power.

19. A mounting board of an array-type multilayer ceramic electronic component comprising:
a printed circuit board having a plurality of first and second electrode pads disposed thereon with predetermined intervals therebetween in a length direction while opposing each other in a width direction; and
the array-type multilayer ceramic electronic component of any one of claims 1, 9 and 14 mounted on the plurality of first and second electrode pads.
